# EUROPÄISCHE PATENTSCHRIFT

(11) **EP 3 601 955 B1**
(45) Veröffentlichungstag und Bekanntmachung des Hinweises auf die Patenterteilung: **12.05.2021**
(21) Anmeldenummer: 18723407.5
(22) Anmeldetag: 15.03.2018
(51) Int. Cl.: G01D 5/14, G01R 33/07

(54) **STÖRFELDKOMPENSIERTE WINKELSENSORVORRICHTUNG UND VERFAHREN ZUR STÖRFELDKOMPENSIERTEN WINKELBESTIMMUNG**
INTERFERENCE FIELD-COMPENSATED ANGLE SENSOR DEVICE AND METHOD FOR INTERFERENCE FIELD-COMPENSATED ANGLE DETERMINATION
DISPOSITIF CAPTEUR D'ANGLE À COMPENSATION DES CHAMPS PARASITES ET PROCÉDÉ DE DÉTERMINATION D'ANGLE À COMPENSATION DES CHAMPS PARASITES

(30) Priorität: 28.03.2017 DE 102017106655
(43) Veröffentlichungstag der Anmeldung: 05.02.2020
(73) Patentinhaber: Sensitec GmbH, 35578 Wetzlar (DE)
(72) Erfinder: LEHNDORFF, Ronald, 55130 Mainz (DE); GLENSKE, Claudia, 35638 Leun (DE); WEBER, Sebastian, 35584 Wetzlar (DE)
(74) Vertreter: Spachmann, Holger
(86) Internationale Anmeldenummer: PCT/EP2018/056533
(87) Internationale Veröffentlichungsnummer: WO 2018/177762

(56) Entgegenhaltungen:
- DE-A1- 10 130 988
- DE-A1-102011 080 679
- DE-A1-102011 083 249

## Beschreibung

Die Erfindung betrifft eine störfeldkompensierte Winkelsensorvorrichtung und ein Störfeldkompensationsverfahren, beruhend auf einer magnetfeldbasierten Bestimmung eines Drehwinkels einer Rotationsachse. Dabei erzeugt eine Magnetfelderzeugungseinrichtung ein Magnetfeld, das relativ zu einer Winkelsensoreinrichtung rotiert, wobei die Winkelsensoreinrichtung die Winkelausrichtung des Drehmagnetfeldes bestimmen kann.

### STAND DER TECHNIK

Aus dem Stand der Technik ist eine Vielzahl von magnetfeldbasierten Winkelsensorvorrichtungen bekannt, die kontaktfrei auf Basis magnetoresistiver Widerstandselemente den Drehwinkel einer Rotationsachse bestimmen können. Unter anderem werden derartige Sensoren im Automotive-Bereich und im Bereich elektrischer Maschinen eingesetzt, um beispielsweise einen Drehwinkel oder eine Drehfrequenz einer rotierenden Motor- oder Antriebswelle, einer Radwelle oder einen Lenkradwinkel festzustellen.

Im technischen Umfeld nimmt die Zahl von elektromagnetischen Störquellen, die elektrische oder magnetische Störfelder verursachen, permanent zu. Dies wird auch als Elektrosmog bezeichnet. Elektromagnetische Sensoren, die auf Messung eines elektrischen oder magnetischen Nutzfelds nutzen, müssen in der Lage sein, tolerant gegenüber diesen Störfeldern zu sein, und bis zu einem gewissen Maß eine Messung unter Einfluss eines Störfelds korrekt durchzuführen. Insbesondere im Bereich Automotive fordert die ISO-11452-8:2015 *"Straßenfahrzeuge-Komponentenprüfverfahren für elektrische Störgrößen durch schmalbandige gestrahlte elektromagnetische Energie* - *Teil 8: Störfestigkeit gegen Magnetfelder",* dass elektromagnetische Sensoren, die auf der Erfassung eines magnetischen Nutzfeldes beruhen, Störfelder im Bereich von 1 kA/m bis zu 3 kA/m Feldstärke tolerieren müssen und exakte Werte anzeigen sollen.

Somit sind in jüngster Zeit Versuche unternommen worden, Störfeldkompensationsmaßnahmen zu entwickeln, die versuchen, magnetische Störfelder bei Winkelmesssensoren zu kompensieren.

So wird beispielsweise von Thomas Tille: "Automobil-Sensorik, ausgewählte Sensorprinzipien und deren automobile Anwendung", BMW AG, Springer Vieweg Verlag, 2016, ISBN 978-3-662-48943-7 auf den Seiten 242 bis 250 ein in einer Welle integriertes magnetisches Winkelsensorsystem vorgestellt, bei dem ein Winkelsensor von einer ferromagnetischen Hohlzylinderwandung der Welle umschirmt ist, um Störfelder kompensieren zu können. Eine derartige elektromagnetische Abschirmung des Winkelsensors erfordert einen hohen konstruktiven Aufwand und lässt sich nur in wenigen Anwendungsfällen praxisgerecht einsetzen.

Daneben ist beispielsweise aus der WO 1998/054547 A1 ein Winkelmesssensor auf Hall-Basis bekannt, bei dem vier Hall-Widerstände in einer Brückenschaltung angeordnet sind, wobei jeder Widerstand eine vektorielle Komponente eines Drehmagnetfeldes messen kann und die vier Widerstände der Messbrücke axial verteilt um eine Rotationsachse angeordnet sind, um die Wirkung eines Störmagnetfeldes kompensieren zu können. Somit wird ein einzelner Winkelsensor radial vergrößert, um ein nahezu homogenes Störmagnetfeld durch die gegengerichteten Ausrichtungen der einzelnen Widerstandselemente der Messbrücke kompensieren zu können. Hierzu wird eine relativ große Chipfläche benötigt bzw. eine Vergrößerung der Sensorvorrichtung erforderlich, die in vielen Fällen nicht praxisgerecht ist.

Des Weiteren betrifft die US 8,659,289 B2 eine magnetfeldbasierte Winkelmesssensorvorrichtung, die zwei Winkelmesssensoren umfasst, wobei jeder Winkelmesssensor einer Magnetfelderzeugungseinrichtung, sprich einem Permanentmagneten, zugeordnet ist, und ein für sich bereitgestelltes Drehmagnetfeld des Permanentmagneten misst. Die Magnetfelder, die auf die beiden Winkelmesssensoreinrichtungen einwirken, sind unabhängig voneinander. Die relative Lage der Winkelmesssensoreinrichtungen bezüglich der Magnetfelderzeugungseinrichtung ist identisch, lediglich die Ausrichtung des Nutzmagnetfelds ist geändert, um derart Einflüsse eines Störfeldes kompensieren zu können. Die herausgegebenen beiden Winkel der beiden Winkelmesssensoreinrichtungen werden miteinander verrechnet entsprechend der relativen Lage der Nutzmagnetfelder und der Winkelmesseinrichtungen zueinander. Da die Winkelmesseinrichtungen unterschiedlichen Magnetfeldern verschiedener Permanentmagneten ausgesetzt sind bzw. unterschiedliche Magnetflüsse von einer Magnetfelderzeugungseinrichtung sehen, kann eine Kompensation beruhend auf einer abgestimmten Bereitstellung der verschiedenen Magnetfelder und einem identischen Verhalten der Winkelmesssensoreinrichtungen erreicht werden. Hierzu ist eine relativ kostspielige und exakte Herstellung der Winkelmesssensorvorrichtung notwendig, die ein entsprechend kostenintensives Verfahren und einen entsprechend teueren Sensor zur Folge hat.

Die DE 10 2016 202 378 A1 betrifft eine Winkelsensorvorrichtung, wobei im Sinne der Erfindung ein Gesamtsystem mit Winkelsensoreinrichtung (elektrischer Teil) und Magnetfelderzeugungseinrichtung mit rotierenden Magneten (mechanischer Teil) mit einer Winkelmesssensoreinrichtung (nur elektrischer Teil) gemeint ist, und die Winkelmesssensoreinrichtung einen Winkelsensor mit zwei voneinander abgewinkelten Gruppen von sensitiven Elementen umfasst, der dazu ausgelegt sind ein Winkelsignal auszugeben. Der Winkelsensor umfasst eine erste Gruppe von sensitiven Elementen und eine zweite Gruppe mit sensitiven Elementen. Die erste Gruppe ist ausgelegt, ein Magnetfeld entlang einer ersten Richtung zu erfassen, die zweite Gruppe ist ausgelegt, das Magnetfeld entlang einer zweiten Richtung, vorzugsweise 90° zur ersten Richtung zu erfassen. Eine Auswerteeinheit bestimmt aus den Signalen der sensitiven Elemente der ersten und zweiten Gruppe ein Winkelsignal. Somit wird ein Winkelsensor vorgeschlagen, bei dem ein Sinus-und ein Kosinus-Signal jeweils mit drei magnetoresistiven Elementen gemessen und zu einem einzigen Winkelsignal bestimmt werden. In weiteren Ausbildungen wird vorgeschlagen, jeweils das Sinus- und das Kosinus-Signal redundant durch Messung von jeweils zwei der drei sensitiven Elemente zu ermitteln, und somit zwei oder mehrere Sinus- und Kosinus-Werte zu mitteln. Es wird allerdings in jedem Fall nur ein einziger Winkelwert bestimmt, so dass im Sinne der Erfindung nur von einem einzigen Winkelsensor gesprochen werden kann, der nur einen einzelnen Gradienten ausgibt.

Die DE 10 2014 109 693 A1 betrifft eine gattungsgemäße Winkelsensorvorrichtung mit einem rotierenden mehrpoligen Dauermagneten, und einer Winkelmesssensoreinrichtung, die einen Winkelsensor mit zumindest Hall-Elementen umfasst, die entlang einer Kreisbahn angeordnet sind, und deren Signale zur Bestimmung einer Winkelposition mittels dargestellter trigonometrischer Beziehungen verrechnet werden. In einer Variante schlägt ein Vorsehen dreier weiterer Hall-Elemente eines zweiten Winkelsensors vor, die entlang der Kreisbahn versetzt zu den ersten Hall-Elementen angeordnet sind. Differenzen in der Winkelbestimmung durch beide Winkelsensoren können ein Störfeld minimieren. In der DE 10 2014 109 693 A1 kann somit die Anwendung zweiter Winkelsensoren zur Störfeldkompensation erkannt werden. Allerdings sind die Hall-Elemente der beiden Winkelsensoren auf einer gemeinsamen Kreisbahn abgewinkelt versetzt zueinander angeordnet, wobei keine axiale oder radiale Versetzung der Winkelsensoren zur Rotationsachse erkennbar. Dabei ist kein Gradient von Winkelwerten der beiden Winkelsensoren bestimmt, sondern es werden mittels komplizierter trigonometrischer Beziehungen Störfelder durch Gradientenbestimmung von einzelnen Sensorelementwerten berechnet.

Aus der DE 10 2010 040 584 A1 geht ebenfalls eine Winkelsensorvorrichtung mit einer Winkelsensoreinheit hervor, die einen Winkelsensor umfasst, der zwei Sensorelemente umfasst. Diese sind in einer Kreisbahn um einen rotierenden Magneten angeordnet und stellen ein Sinus- und Kosinussignal bereit. Die DE 10 2010 040 584 A1 empfiehlt, die Wirkung eines Störfelds z.B. vor Inbetriebnahme zu ermitteln und beispielsweise in Form von Kennlinien oder Berechnungsregeln bei der Ermittlung des Winkelwerts von den Sensorsignalen abzuziehen. Insofern offenbart die DE 10 2010 040 584 A1 nur einen Winkelsensor und versucht, bereits im Vorfeld statische, oder in Prüf- oder Simulationsszenarien dynamisch auftretende Fremdfeldeinflüsse aktiv zu kompensieren, wozu eine entsprechende Auswertelogik bzw. Rechnerkapazität bereitgestellt werden muss. Dabei kann die DE 10 2010 040 584 A1 nicht auf unerwartete Fremdfeldeinflüsse reagieren und weist auch keine zwei Winkelsensoren zur unabhängigen Ermittlung zweier Winkelwerte auf. Auch kann keine radiale oder axiale Versetzung derartiger Winkelsensoren gegenüber der Rotationsachse erkannt werden.

Weiterhin betrifft die DE 10 2013 205 313 A1 eine Winkelsensorvorrichtung mit einer Winkelsensoreinrichtung, die einen aus zumindest drei diagonal gegenüberliegenden Paaren von kreisförmig angeordneten Hallsensoren bestehenden Winkelsensor umfasst. Die hervorgehenden drei oder mehreren Messsignale der Hallsensorpaare werden zu einem gemeinsamen Winkelsignal verrechnet. Insofern weist das Konzept der DE 10 2013 205 313 A1 Gemeinsamkeiten mit dem Konzept der DE 10 2016 202 378 A1 und DE 10 2014 109 693 A1 auf, da eine redundante Anzahl von Sensoren in einem Winkelsensor vorgesehen ist, um Störfelder zu eliminieren. Allerdings sind auch in der DE 10 2013 205 313 A1, wie in den übrigen Druckschriften, keine explizit getrennte Winkelsensoren zur unabhängigen Erfassung zweier Winkelwerte angegeben, und es ist ebenfalls keine axiale oder radiale Versetzung der Winkelsensoren bzw. der hieraus beruhenden Sensorelemente erkennbar.

Die DE 10 2011 083249 A1 offenbart mehrere Winkelsensorvorrichtungen mit einer Magnetfelderzeugungseinrichtung und einer Winkelsensoreinrichtung, die zwei Winkelsensoren umfassen. Dabei rotiert ein Magnetfeld der Magnetfelderzeugungseinrichtung relativ zur Winkelsensoreinrichtung, wobei in diesen Vorrichtungen unterschiedliche Magnetfeldbereiche des Magnetfelds der Magnetfelderzeugungseinrichtung erfasst werden. Ein erster Winkelsensor befindet sich an einer ersten Position und ein zweiter Winkelsensor 20 befindet sich an einer zweiten Position befindet, wobei sich die Bezugsrichtungen des ersten Winkelsensors und des zweiten Winkelsensors sich unterscheiden. Beide Winkelsensoren weisen desselben Abstands zur Magnetfelderzeugungseinrichtung auf und messen identische Amplituden des Nutzmagnetfelds.

Aus der DE 10 2011 080679 A1 geht eine Winkelsensorvorrichtung mit zwei Magnetfelderzeugungseinrichtungen hervor, wobei zwei Magnetfeldsensoren in entgegengesetzt ausgerichteten Magnetfeldbereichen getrennter Nutzfelder der beiden Magnetfelderzeugungseinrichtungen angeordnet sind. Daneben zeigt diese Druckschrift auch eine Winkelsensorvorrichtung mit einer Magnetfelderzeugungseinrichtung, wobei die beiden Winkelsensoren in Bereichen entgegengesetzter Magnetfeldausrichtung angeordnet sind.

Schließlich betrifft die DE 101 30 988 A1 eine justierbare Winkelsensorvorrichtung mit einem aus zwei gegeneinander abgewinkelt ausgerichteten magnetoresistiven Messbrücken. Durch einen Korrekturfaktor der Messbrückensignale wird die Genauigkeit des Winkelsensors erhöht.

Ausgehend von dem obigen Stand der Technik ist es Aufgabe der Erfindung, eine Winkelmesssensorvorrichtung vorzuschlagen, die kostengünstig und einfach herzustellen ist, und die eine effektive Kompensation eines Störfeldes ohne großen konstruktiven Aufwand ermöglicht.

Diese Aufgabe wird durch eine Winkelmesssensorvorrichtung und ein Winkelmesssensorverfahren nach den unabhängigen Ansprüchen gelöst.

Vorteilhafte Ausbildungen der Erfindung sind Gegenstand der Unteransprüche.

Wesentlich für die Erfindung ist die Tatsache, dass die Winkelsensoren axial in verschiedenen Abständen entlang der Rotationsachse und/oder die Winkelsensoren radial in verschiedenen Abständen zur Rotationsachse angeordnet sind.

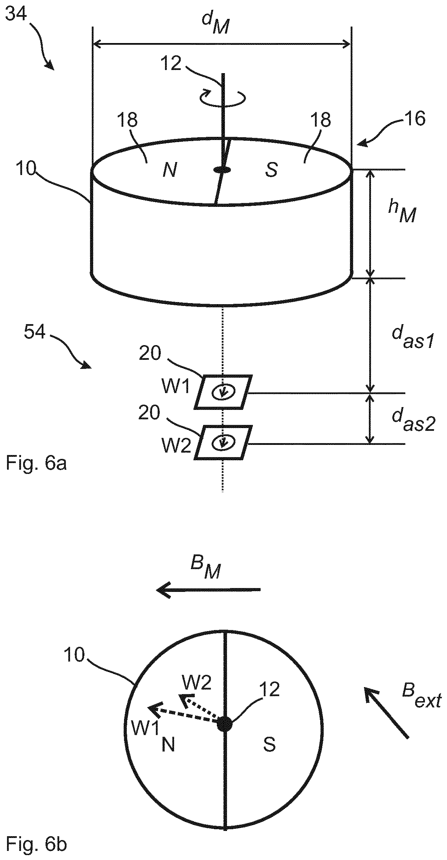

Daher fallen nur die Anordnungen der Fig. 6-11 unter den Gegenstand von Anspruch 1 und die folgende Beschreibung ist auch so zu interpretieren.

### OFFENBARUNG DER ERFINDUNG

Erfindungsgemäß wird eine störfeldkompensierte Winkelsensoreinrichtung zur magnetfeldbasierten Bestimmung eines Drehwinkels einer Rotationsachse vorgeschlagen, die zumindest eine Magnetfelderzeugungseinrichtung, insbesondere einen Permanentmagneten, und eine Winkelsensorvorrichtung umfasst, wobei ein Magnetfeld (Nutzmagnetfeld) der Magnetfelderzeugungseinrichtung relativ zur Winkelsensoreinrichtung rotiert. Dies bedeutet, dass entweder der Permanentmagnet ruht und die Winkelsensoreinrichtung mit der Rotationsachse rotiert, oder die Magnetfelderzeugungseinrichtung mit der Rotationsachse rotiert und die Winkelsensoreinrichtung ruht.

Die Erfindung schlägt vor, dass die Winkelsensoreinrichtung zumindest zwei Winkelsensoren umfasst, die axial und/oder radial zur Rotationsachse versetzt angeordnet sind, so dass durch eine algebraische Auswertung der Winkelwerte oder der Sensorsignale der zumindest zwei Winkelsensoren ein Einfluss eines Störfeldes kompensierbar ist.

Mit anderen Worten umfasst die Winkelsensorvorrichtung zumindest zwei Winkelsensoreinrichtungen, wobei jede der Winkelsensoreinrichtungen eingerichtet ist, den Winkel eines Magnetfelds zu erfassen, Sensorsignale, insbesondere einen Sinus- und einen Cosinuswert auszugeben, die durch eine Arcustangensoperation einen Winkelwert des Nutzmagnetfeldes ergeben. Die zumindest zwei Winkelsensoren der Winkelsensoreinrichtung sind axial gegeneinander versetzt angeordnet und/oder radial zur Rotationsachse versetzt angeordnet. Dementsprechend erfassen die beiden Winkelsensoren unterschiedliche Magnetfeldbereiche eines einzelnen Nutzmagnetfelds der Magnetfelderzeugungseinrichtung. Hierdurch wird es beispielsweise bei einer axialen Versetzung möglich, verschiedene Amplitudenwerte des Nutzmagnetfelds der Magnetfelderzeugungseinrichtung zu erfassen, oder bei einer radialen Versetzung kann es möglich sein, unterschiedliche Phasenwerte des Nutzmagnetfelds der Magnetfelderzeugungseinrichtung zu erfassen, insbesondere wenn die beiden Winkelsensoren kreisförmig um den Umfang der Rotationsachse versetzt angeordnet sind, oder amplitudenmäßig unterschiedliche Werte des Magnetfelds der Magnetfelderzeugungseinrichtung erfassen. Ein von außen erzeugtes Störfeld wirkt, da die beiden Winkelsensoren im Verhältnis zur Störfeldquelle dicht benachbart sind, auf beide Winkelsensoren gleich. Hierdurch kann sich ein Gradient, d. h. ein Unterschied der Winkelerfassung bzw. der Sensorsignale der beiden Winkelsensoren ergeben. So kann beim Vergleich einer ungestörten Winkelsensoreinrichtung und einer gestörten Winkelsensoreinrichtung und den sich hieraus ergebenden unterschiedlichen Gradienten der ausgegebenen Winkel oder der Sensorsignale der beiden Winkelsensoren die Größe und eventuell auch die Richtung des Störfeldes bestimmt werden, wobei der Einfluss des Störfeldes arithmetisch oder hardwareseitig kompensiert bzw. minimiert oder eliminiert werden kann. Der Gradient kann durch eine Hardwareverdrahtung ermittelt oder durch eine Softwarebearbeitung bestimmt werden.

Insoweit beruht die Erfindung auf der Idee, unterschiedliche Einflüsse des Nutzmagnetfelds der Magnetfelderzeugungseinrichtung durch eine radial oder axial versetzte Anordnung von Winkelsensoren der Winkelsensoreinrichtung zu erfassen, und bei einem nahezu gleichen Einfluss eines Störmagnetfelds und den bekannten Unterschieden der Winkelerfassung aufgrund der Versetzung kann die Größe des Störfelds bestimmt und/oder dessen Einfluss kompensiert werden. In der praktischen Umsetzung kann zumindest ohne Wissen über Größe und Richtung des Störfeldes dessen Einfluss reduziert oder kompensiert werden.

Insofern umfasst die erfindungsgemäße störfeldkompensierte Winkelsensorvorrichtung zur magnetfeldbasierten Bestimmung eines Drehwinkels einer Rotationsachse eine Magnetfelderzeugungseinrichtung (Permanentmagneten) und eine Winkelsensoreinrichtung, wobei ein Magnetfeld der Magnetfelderzeugungseinrichtung relativ zur Winkelsensoreinrichtung rotiert. Erfindungswesentlich wird vorgeschlagen, dass die Winkelsensoreinrichtung zumindest zwei getrennte Winkelsensoren umfasst, die axial und/oder radial zur Rotationsachse versetzt angeordnet sind und die zwei unabhängige Winkelwerte ausgeben können, so dass durch eine Gradientenbestimmung der Winkelwerte der Winkelsensoren ein Einfluss eines Störfeldes kompensierbar ist.

In einer vorteilhaften Weiterbildung der Erfindung kann die Magnetfelderzeugungseinrichtung als Permanentmagnet, insbesondere Dipolmagnet mit zwei ausgeprägten Magnetpolen, ausgebildet sein, bevorzugt als scheibenförmiger Dipolmagnet mit einer Kreisscheibenhälfte als Nordpol und einer Kreisscheibenhälfte als Südpol, der an einer Stirnfläche der Rotationsachse drehfest angeordnet ist, wobei die Winkelsensoreinrichtung in axialer Verlängerung der Rotationsachse gegenüber zur Stirnfläche der Rotationsachse angeordnet ist. Hierdurch wird vorgeschlagen, dass drehfest mit der Rotationsachse ein Permanentmagnet angeordnet ist, der insbesondere ein Dipolmagnet mit zwei ausgezeichneten Magnetpolen umfasst. Die beiden Magnetpole sind derart angeordnet, dass sie ein Gradientenfeld in Richtung Drehachse ausbilden, insbesondere als scheibenförmiger Magnet mit einer halben Kreisscheibe, die als Nordpol und einer halben Kreisscheibe, die als Südpol magnetisiert ist. Daraus bildet sich ein in beide Richtungen des Permanentmagneten ausgebildetes U-förmiges oder keulenförmiges Magnetfeld, in dem Winkelsensoren der Winkelsensoreinrichtung in einer sensitiven Messebene senkrecht zur Rotationsachse oder parallel zur Rotationsachse angeordnet sein können, um eine Winkelstellung des Nutzmagnetfelds der Magnetfelderzeugungseinrichtung messen zu können. Die Winkelsensoreinrichtung kann grundsätzlich entweder in Verlängerung der Rotationsachse oder rückversetzt entlang der Rotationsachse angeordnet sein, wobei dabei insbesondere eine radiale Versetzung der Winkelsensoreinrichtung von Vorteil ist, insbesondere wenn nur ein geringer Bauraum zur Verfügung steht. Ist die Winkelsensoreinrichtung in Verlängerung der Rotationsachse angeordnet, so können die Winkelsensoren sowohl entlang der Rotationsachse als auch radial versetzt angeordnet sein, es kann eine hohe Genauigkeit bei der Positionierung der Winkelsensoreinrichtung erreicht werden, so dass eine hohe Genauigkeit der Winkelerfassung ermöglicht werden kann.

In einer vorteilhaften Weiterbildung beruhen die Winkelsensoren auf einer xMR-Sensortopologie, insbesondere einer AMR, TMR oder GMR magnetoresistiven Sensortopologie. Die als xMR-Winkelsensoren bezeichneten Sensortypen zeichnen sich gegenüber Hall-Sensoren durch eine bis zu 50-mal höhere Sensitivität aus, so dass diese insbesondere im Schwachfeldbetrieb mit Feldstärken <1kA/m hochgenaue Winkelbestimmungen ermöglichen. MR-Sensoren können das Erdmagnetfeld für Kompassanwendungen erfassen und werden erfolgreich für zerstörungsfreie Materialprüfung und Fahrzeugerkennung eingesetzt. In diesen Anwendungen werden extrem schwache Magnetfelder sehr genau gemessen. Des Weiteren weisen xMR Winkelsensoren typischerweise eine höhere Genauigkeit von bis zu 0,1° auf, ohne dass dazu die Sensorsignale aufwändig nachbearbeitet werden müssen. Dies führt gleichzeitig zu einer höheren Bandbreite da keine Signalkonditionierungsverfahren wie z.B. das Spinning Current Prinzip zur Erzielung einer hohen Winkelgenauigkeit, deutlich besser als 1°, erforderlich sind. Diese Art von Sensoren beruhen teilweise auf Dünnschichteffekten, und teilweise auf magnetoresistive Eigenschaften einer vormagnetisierten Schicht, wobei der Stromfluss abgewinkelt zur inneren Magnetisierung ist, um eine hochgenaue Auflösung der Magnetfeldrichtung zu ermöglichen.

In einer vorteilhaften Weiterbildung kann jeder Winkelsensor eine Wheatstone-Messbrücke aus magnetoresistiven Widerstandselementen umfassen, wobei die Wheatstone-Messbrücken der verschiedenen Winkelsensoren hart verdrahtet sind und einen störfeldkompensierten Winkelsensorwert ausgeben. Jeder Winkelsensor umfasst in der Regel zwei Wheatstone-Messbrücken, die eine Sinus- und eine Cosinus-Komponente eines Magnetfelds bestimmen können, und die bei GMR- und TMR-Sensoren n der Regel 90° und beim AMR-Sensoren in der Regel um 45° zueinander versetzt auf einem Chipsubstrat angeordnet sind. Die Winkelsensoreinrichtung umfasst zumindest zwei oder mehrere Winkelsensoren, die aufgrund einer unterschiedlichen räumlichen Anordnung im Nutzmagnetfeld der Magnetfelderzeugungseinrichtung unterschiedliche Empfindlichkeiten für ein Störmagnetfeld aufweisen. Des Weiteren können aufgrund der räumlichen Lage auch ein Phasenversatz oder ein Amplitudenversatz des Nutzmagnetfelds auftreten. Durch eine phasenrichtige Verschaltung der einzelnen Messbrücken der verschiedenen Winkelsensoren kann ein störfeldkompensierter Winkel bestimmt werden, indem der Einfluss des Störmagnetfelds durch die unterschiedliche Lokalisation der Winkelsensoren ausgeglichen werden kann. Somit gibt die Winkelsensoreinrichtung einen kompensierten Winkel aus und es braucht keine nachträgliche Bearbeitung verschiedener Winkel erfolgen, um den Einfluss eines Störmagnetfelds herausrechnen zu können.

Beispielsweise können zwei oder mehrere Winkelsensoren in einem Umfangskreis um die Rotationsachse angeordnet sein, und um vorgegebene Winkel, zum Beispiel 90° oder 180° gegeneinander versetzt sein. Somit kann ein Brückenwiderstand eines Winkelsensors, der eine Sinuskomponente erfasst, hart verdrahtet mit einer Cosinus-Messbrücke eines um 90° oder phasenvertauscht mit einer um 180° versetzen Sinus-Messbrücke eines um 180° versetzten Winkelsensors verdrahtet sein. Beide Winkelsensoren unterliegen dem gleichen Einfluss eines Störmagnetfelds, wobei sich durch die phasenrichtige Zusammenschaltung der verschiedenen Widerstandsbrücken der Einfluss des Störmagnetfelds kompensieren lässt.

In einer vorteilhaften Weiterbildung kann eine Winkelberechnungseinrichtung umfasst sein, die Winkelwerte oder Sensorsignale jedes Winkelsensors der Winkelsensoreinrichtung empfängt und zur Berechnung eines störfeldkompensierten Winkelwerts verarbeitet. So ist es denkbar, dass zwei oder mehrere Winkelsensoren der Winkelsensoreinrichtung ihren Winkelwert der Winkelberechnungseinrichtung zuführen, und in einer Winkelberechnungseinrichtung diese Winkelwerte beispielsweise unter Berücksichtigung einer arithmetischen Funktion, von tabellierten Werten, Kennfeldern oder dergleichen zur Störfeldkompensation miteinander verrechnet werden. Der Gradient, d. h. die Abweichung der Winkelwerte oder Sensorsignalwerte der einzelnen Winkelsensoreinrichtungen, kann beispielsweise in einem Kalibrierungs- oder Messverfahren für eine störfeldfreie und eine störfeldbehaftete Winkelmessung aufgenommen werden, um so Größe und auch Richtung eines Störfeldes ausrechnen zu können. So kann beispielsweise mit einer entsprechenden Tabelle oder einem Kennfeld die Größe und Richtung des Störfeldes bestimmt werden. In der Praxis kann eine Kompensation auch durch einen Wichtung mit einem einzelnen Faktor erreicht werden, durch den ein nahezu störfeldfreier Winkelwert aus den zwei Sensorsignalen erzeugt wird. Ein Ermitteln von Größe und Richtung des Störfeldes ist hierzu nicht zwingend erforderlich.

In einer vorteilhaften Weiterbildung sind zumindest zwei oder mehrere der in der Winkelsensoreinrichtung umfassten Winkelsensoren achszentrisch angeordnet. Durch eine achszentrische Anordnung erfassen die Winkelsensoren den gleichen Winkelwert des Nutzmagnetfelds in Superposition mit dem Störfeld, jedoch ist der Einfluss des Nutzmagnetfelds mit zunehmendem Abstand entlang der Achse verringert. Dadurch wirkt sich ein Störfeld auf die weiter entfernten Winkelsensoren stärker aus als auf die näherliegenden Winkelsensoren, was in abweichenden Messwinkeln resultiert. Hierdurch ergibt sich eine Abweichung der Winkelwerte, wobei der Winkelwert des näher an der Magnetfelderzeugungseinrichtung liegenden Winkelsensors näher am Nutzfeldwinkel liegt, als der Winkelwert des entfernten Winkelsensors. Durch den Gradienten der Winkelabweichung oder der Sensorsignale zwischen den Winkelsensoren und deren Distanzen von der Magnetfelderzeugungseinrichtung kann dieser Einfluss signifikant kompensiert werden. In der Praxis ist eine vollständige Kompensation nur mit hohem Aufwand erzielbar, allerdings ist eine deutliche Verringerung des StörfeldEinflusses relativ einfach erreichbar.

In einer Weiterbildung der vorgenannten Ausführungsform kann vorteilhaft jeder Winkelsensor einer Wheatstone-Messbrücke magnetoresistive Widerstandselemente umfassen, wobei die radialen Abstände der magnetoresistiven Widerstandselemente der Wheatstone-Messbrücke jedes Winkelsensors von der Rotationsachse verschieden sind. So kann beispielsweise jeder einzelne Winkelsensor nicht nur Widerstände für zwei Messbrücken, sondern für vier oder mehrere Messbrücken umfassen, wobei die einzelnen Widerstände, beispielsweise für die Sinus- und die Cosinus-Messbrücke achszentrisch angeordnet sind, jedoch verschiedene Radien zur Drehachse aufweisen. Hierbei weisen - je nach Struktur des Nutzmagnetfelds - die weiter entfernt von der Drehachse angeordneten Widerstände einen stärkeren oder schwächeren Einfluss des Nutzmagnetfeldes auf. Die Widerstände der Brückenschaltungen können derart miteinander verdrahtet sein, dass der Einfluss eines Störmagnetfeldes, der sich auf alle Widerstände des Winkelsensors gleich auswirkt, kompensiert werden kann. Insbesondere bei einem achszentrisch angeordneten Winkelsensor können somit zwei oder mehrere entlang eines Kreises oder Rechtecks um die Achse angeordneten Widerstandselemente den Einfluss eines Störmagnetfelds durch eine Gradientenbildung berücksichtigen, wobei die einzelnen Widerstände hart verdrahtet in der Wheatstone-Messbrücke miteinander verschaltet sein können.

In einer vorteilhaften Weiterbildung des vorigen Ausführungsbeispiels können radial versetzte magnetoresistive Widerstandselemente der Winkelsensoren gegensinnig zu einer sich kompensierenden Wheatstone-Messbrücke verschaltet sein. So ist beispielsweise denkbar, einen Winkelsensor achszentrisch anzuordnen und entlang eines Umfangskreises oder eines Umfangsrechtecks Widerstandselemente für die Sinus- und die CosinusBrücken anzuordnen, wobei zwei oder mehrere radiale Umfangkreise oder Umfangsrechtecke vorgesehen sind. Somit sind zugehörige magnetresistive Widerstandselemente zweier oder mehrerer Messbrücken in einer radialen Versetzung anordenbar. Radial versetzte Widerstandselemente können gegensinnig in einer Messbrücke verschaltet sein. Ein Nutzmagnetfeld wirkt sich auf die radial versetzten Widerstandselemente verschieden aus, während ein Störmagnetfeld sich gleichartig auswirkt. Durch die gegensinnige Verschaltung der Widerstandselemente in der Messbrücke kann der Einfluss des Störmagnetfeldes, der sich für alle Widerstandselemente gleich auswirkt, kompensiert werden. Hierdurch ist eine effektive und bauliche einfache Maßnahme zur Kompensation eines Störmagnetfelds gegeben, wobei ein entsprechend großflächiger Chip vorgesehen werden kann. Günstigerweise wirkt sich der Einfluss des Nutzmagnetfelds auf eine Gruppe von Widerstandselementen, die sich entlang eines der geschlossenen Umfangskreise oder Umfangsrechtecke angeordnet sind, besonders stark gegenüber einer weiteren Gruppe aus, die radial versetzt ist. Es ist gleichwohl denkbar, dass die beiden Gruppen radial und auch axial zueinander versetzt sind.

In einer vorteilhaften Weiterbildung kann eine radiale Position der Winkelsensoren verschieden sein, insbesondere können zumindest zwei Winkelsensoren radial gegenüberliegend angeordnet sein, oder bevorzugt vier Winkelsensoren auf einer Kreisbahn jeweils um 90° versetzt um die Rotationsachse angeordnet sein. Hierdurch werden radial beabstandete Winkelsensoren vordefinierter Versetzungswinkel, insbesondere 90° oder 180°, vorgeschlagen, die in der Winkelsensoreinrichtung umfasst sind. Die Winkelsensoren messen das Nutzmagnetfeld in einer vorgegebenen Phasenlage, dazu sind sie insbesondere mit ihrer sensitiven Messfläche parallel zur Rotationsachse ausgerichtet und können beispielsweise bei einer 90°-Versetzung in 90°-Phasen ein Drehfeld des Nutzmagnetfelds messen. Ein Störmagnetfeld würde auf alle Winkelsensoren den gleichen Einfluss haben, und kann bei einem phasenrichtigen Zusammenfassen der Winkelwerte der einzelnen Winkelsensoren kompensiert werden. Dabei gibt es die Möglichkeit, die einzelnen Messbrücken der Winkelsensoren fest zu verdrahten, so dass ein gemeinsamer Winkelwert beispielsweise durch eine ArcTangens-Bildung ohne aufwändige Berechnungseinheit ausgegeben werden kann. Alternativ oder zusätzlich können die einzelnen Winkelwerte der einzelnen Winkelsensoren in einer Berechnungseinheit miteinander verbunden werden, um den Einfluss des Störmagnetfelds rechnerisch kompensieren zu können.

In einer vorteilhaften Weiterbildung des vorherigen Ausführungsbeispiels kann die Magnetfelderzeugungseinrichtung einen Permanentmagneten mit einer gleichen Anzahl von Polen wie Winkelsensoren umfassen, insbesondere ein Quadropolmagnet umfassen. Hierbei wird in Bezug auf das vorhergehende Ausführungsbeispiel vorgeschlagen, eine Ausführung einer Winkelsensoreinrichtung mit vier um 90° versetzte Winkelsensoren sowie einen Quadropolmagneten als Magnetfelderzeugungseinrichtung einzusetzen, wobei der Quadropolmagnet jeweils um 90° versetzte Kreissegmente mit alternierender Polarität aufweist. In dieser Ausführungsform kann die Winkelsensoreinrichtung je nach eingesetzter Widerstandstechnik 90°- oder 180°-Drehungen erfassen, wobei alle Winkelsensoren im Idealfall starr phasenversetzte Werte anzeigen und bei einer auftretenden Phasendifferenz der entlang einer Y-Achse angeordnete Sensoren eine Abweichung der Drehachse in X-Richtung hin detektiert werden kann. Dabei ist eine Zustandsüberwachung der Rotationsachse, insbesondere bei wanderndem Drehpunkt möglich, da sich in diesem Fall eine Signal- bzw. Phasendifferenz ergeben würde. Somit kann eine Überwachung der Rotationsachsenlage ermöglicht werden.

In einer vorteilhaften Weiterbildung kann die axiale Position der zumindest zwei Winkelsensoren, insbesondere zumindest zweier Gruppen von Winkelsensoren verschieden sein. Durch eine axial verschiedenartige Positionierung der Winkelsensoren oder der Gruppen von Winkelsensoren ist die Amplitude des Nutzmagnetfelds auf jeden Winkelsensor verschieden. Jeder Winkelsensor oder jede Gruppe von Winkelsensoren würde aber den gleichen Winkel des Nutzmagnetfeldes bestimmen. Der Einfluss des Störmagnetfeldes ist auf alle Sensoren gleich, so dass durch den Gradienten der an verschiedenen axialen Positionen angeordneten Winkelsensoren der Einfluss des Störmagnetfelds bestimmt werden kann. Der Einfluss kann rein rechnerisch oder mittels einer Kennlinie oder einem Kennfeld bestimmt werden. Je größer der axiale Abstand der Winkelsensoren ist, umso stärker würde ein Messwinkel vom Störmagnetfeld beeinflusst werden. Beispielsweise kann ein Korrekturfaktor in Abhängigkeit eines bekannten Nutzfeldes und verschiedener Störfelder bestimmt werden, und durch eine Korrekturrechnung, beispielsweise ausgehend vom Winkelwert des axial am nächsten liegenden Winkelsensors zur Magnetfelderzeugungseinrichtung und auf Basis eines Gradienten der beiden Winkel oder der zugrundeliegenden Sensorsignale der axial versetzten Winkelsensoren mittels des Korrekturfaktors eine Korrektur zu einem wahren Winkelwert, bestimmt werden. Hierzu kann eine Kennlinie für verschiedene Stärken von Nutz- und Störfeldern vorgesehen sein. Auch kann ein weiterer, extern angeordneter Magnetfeldsensor zur Erfassung der Größe des Störmagnetfelds vorgesehen sein, um mit dessen Hilfe einen geeigneten Korrekturwert auszuwählen.

In einem nebengeordneten Aspekt der Erfindung wird ein Verfahren zur störfeldkompensierten Winkelbestimmung einer Rotationsachse unter Verwendung einer Winkelsensorvorrichtung vorgeschlagen, bei der eine vorgenannte Ausführungsform einer Winkelsensorvorrichtung eingesetzt wird, und bei der eine Winkelabweichung zwischen den zumindest beiden Winkelsensoren der Winkelsensoreinrichtung zur Kompensation eines externen Störfelds herangezogen werden kann. So kann der Gradient, d. h. die Winkelabweichung oder eine Sensorsignalabweichung zwischen den zumindest zwei Winkelsensoren, die axial und/oder radial entlang der Rotationsachse versetzt angeordnet sind, und die dem Einfluss eines Nutzmagnetfeldes einer Magnetfelderzeugungseinrichtung ausgesetzt sind, genutzt werden, um ein externes Störfeld bestimmen und kompensieren zu können. Bei einer axialen Versetzung der Winkelsensoren würde durch eine Abnahme der Amplitude des Nutzmagnetfelds aber einen praktisch identischen Einfluss des Störmagnetfelds ein Korrekturwert ermittelt werden können. Bei einer radialen Versetzung kann aufgrund verschiedener Phasen, aber auch verschiedener Amplituden und bei gleichem Einfluss des Störmagnetfelds, aber unterschiedlichem Einfluss des Nutzmagnetfelds eine Korrektur vorgenommen werden, die sowohl hardwaretechnisch als auch rechnerisch eine Kompensationsmöglichkeit bietet. Somit lassen sich effektiv und einfach der Einfluss eines Störmagnetfelds auch bei hohen Störmagnetfeldern, wie sie die ISO-11452-8 aus 2015 vorschreibt, kompensieren und bei Störfeldern mit Feldstärke bis zu 3 kA/m exakte Winkelwerte bestimmen.

In einer vorteilhaften Weiterbildung des Verfahrens kann ein Korrekturfaktor, eine Kennlinie oder ein Kennfeld von Korrekturfaktoren zur Kompensation eines externen Störfeldes herangezogen werden. Insbesondere bei einer arithmetischen Nachbehandlung der Winkelwerte der einzelnen Winkelsensoren kann eine Kennlinie, ein Kennfeld oder ein Korrekturfaktor herangezogen werden, um eine Kompensation des Störmagnetfelds herbeizuführen. Aufbauend auf dem vorgenannten Verfahrensbeispiel kann der Korrekturfaktor die Kennlinie oder das Kennfeld bei Herstellen der Winkelsensorvorrichtung mit einer Kalibration unter Verwendung verschiedener magnetischer Stör- und Nutzfelder bestimmt werden. Der Korrekturfaktor oder die Korrekturfaktoren oder Kennlinien oder Kennfelder kann bzw. können in einem Speicher einer Winkelberechnungseinrichtung gespeichert sein, und kann bei Ermittlung der Winkelwerte der verschiedenen Winkelsensoren berücksichtigt werden.

In einer vorteilhaften Weiterbildung des Verfahrens kann der Korrekturfaktor einen Einfluss eines axialen Abstands der Winkelsensoren und/oder einen radialen Abstand von magnetoresistiven Widerstandselementen der Wheatstone-Messbrücke der Winkelsensoren berücksichtigen. Somit können zum Beispiel mehrere Winkelsensoren, insbesondere vier, acht oder noch mehr Winkelsensoren in verschiedenen axialen und auch radialen Abständen entlang der Rotationsachse angeordnet sein, und deren Störfeldkompensation kann teilweise durch eine hart verdrahtete Schaltung der Widerstandselemente, eventuell auch mit Phasenschiebergliedern, aber auch durch eine arithmetische Nachbehandlung, zum Beispiel durch Korrektur mit Korrekturfaktoren kompensiert werden. Die Korrekturfaktoren können einen axialen Abstand oder einen radialen Abstand der Widerstandselemente berücksichtigen. Es ist denkbar, dass im Laufe der Messung oder in intervallmäßigen Abständen radiale und/oder axiale Abstände der Winkelsensoren geändert werden können, um hierdurch die Kennlinien oder Kennwerte neu zu bestimmen und eine Neukalibrierung der Winkelsensorvorrichtung vornehmen zu können.

### ZEICHNUNGEN

Weitere Vorteile ergeben sich aus der vorliegenden Zeichnungsbeschreibung. In den Zeichnungen sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: schematisch eine Winkelsensorvorrichtung aus dem Stand der Technik,
- Fig. 2: eine Anordnung von Widerstandselementen und eine Widerstandsmessbrücke gemäß des Stands der Technik,
- Fig. 3: radial um 90° versetzte Winkelsensoren,
- Fig. 4: eine hart verschaltete Wheatstone-Messbrücke des in Fig. 3 dargestellten Bespiels,
- Fig. 5: Quadropolmagnet und um 90° versetzte Winkelsensoren,
- Fig. 6: ein Ausführungsbeispiel der Erfindung mit axial versetzten Winkelsensoren,
- Fig. 7: ein weiteres Ausführungsbeispiel der Erfindung, das sowohl axial als auch radial versetzte Winkelsensoren kombiniert,
- Fig. 8: ein weiteres Ausführungsbeispiel mit radial versetzten Widerstandselementen zweier Winkelsensoren,
- Fig. 9: Anordnung von Widerstandselementen und Wheatstone-Messbrücke der in Fig. 8 dargestellten Ausführungsform,
- Fig. 10: ein weiteres Ausführungsbeispiel von axial und radial versetzten Winkelsensoren,
- Fig. 11: schematisch eine Winkelberechnungseinrichtung zum Verarbeiten der Winkelwerte verschiedener Winkelsensoren eines Ausführungsbeispiels.

In den Figuren sind gleichartige Elemente mit gleichen Bezugszeichen beziffert. Die Figuren zeigen lediglich Beispiele und sind nicht beschränkend zu verstehen.

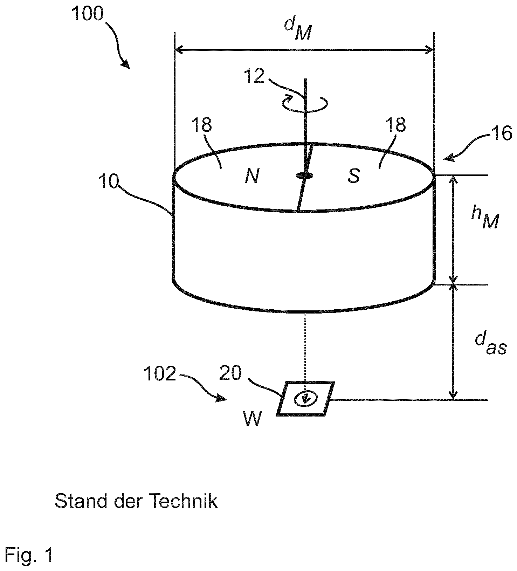

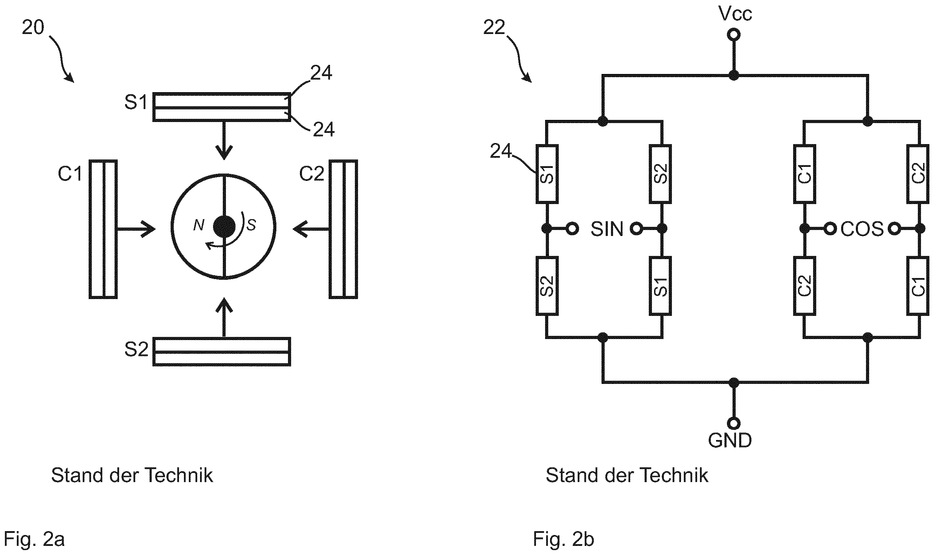

In der Fig. 1 ist ein Ausführungsbeispiel 100 einer Winkelsensorvorrichtung aus dem Stand der Technik dargestellt. Die Winkelsensorvorrichtung 100 weist eine Rotationsachse 12 auf, an deren axialem Ende ein scheibenförmiger Permanentmagnet 10 als Dipolmagnet mit zwei Dipolmagnet-Kreissegmenten als Nord- und Südpol 18 angeordnet ist. Die Magnetfelderzeugungseinrichtung 16, die den drehbaren Dipolmagneten 10 umfasst, ist somit am axialen Ende der Rotationsachse 12 angeordnet. Der Dipolmagnet 10 weist einen Durchmesser *d_{M}* und eine Höhe *h_{M}* auf. In einem axialen Abstand *dₐₛ* vom Dipolmagneten 10 ist ein Winkelsensor 20 einer Winkelsensoreinrichtung 102 angeordnet. Der Dipolmagnet 10 erzeugt ein in axialer Richtung ausgerichtetes U-förmiges Nutzmagnetfeld, das den Winkelsensor 20 durchdringt. Im Winkelsensor 20 ist eine Wheatstone-Messbrücke, wie sie in Fig. 2b dargestellt ist, integriert. Die sensitive Fläche des Winkelsensors 20 ist rechtwinklig zur Achse 12 ausgerichtet.

In einer Draufsicht auf die Chipsubstratfläche des Winkelsensors 20 ist in Fig. 2a die Anordnung der Widerstandselemente für die Sinusbrücke S1, S2 und die Cosinusbrücke C1, C2 dargestellt. Die Widerstandselemente 24 können AMR-, GMR-, TMR- oder allgemein xMR-Widerstandselemente sein. Der Winkelsensor 20 umfasst für den Sinuszweig und für den Cosinuszweig jeweils vier Widerstandselemente, die einzeln kontaktierbar sind. Die Sinuswiderstandselemente S1, S2 sind paarweise gegenüberliegend angeordnet und gegenüber den Cosinuswiderstandselementen C1, C2 um 90° versetzt in einem Quadrat achszentrisch um die Rotationsachse 12 angeordnet.

In der Fig. 2b ist eine Wheatstone-Winkelmessbrücke 22 mit einer phasenrichtigen Verschaltung der beiden Wheatstone-Messbrücken für den Sinus- und den Cosinusteil dargestellt. Jede Messbrücke umfasst vier Widerstandselemente 24, die diagonal gegenüberliegend an der gleichen Stelle auf der Chipsubstratfläche lokalisiert sind. Durch eine Arcustangensbildung des Quotienten von Sinus- und Cosinuswert kann der Winkel des Nutzmagnetfelds bezüglich des Chipsubstrates bestimmt werden. Wirkt ein externes Störmagnetfeld auf die Winkelsensorvorrichtung 100 ein, so überlagert dieses sich mit dem Nutzfeld und führt zu einer Verfälschung des Nutzmagnetfeldwinkels, die umso stärker ausfällt, je stärker das Störmagnetfeld im Verhältnis zum Nutzmagnetfeld ist. Insbesondere bei hohen Störmagnetfeldern von bis zu 3000 A/m können signifikante Winkelverfälschungen auftreten, so dass der Winkel der Rotationsachse nicht exakt bestimmt werden kann.

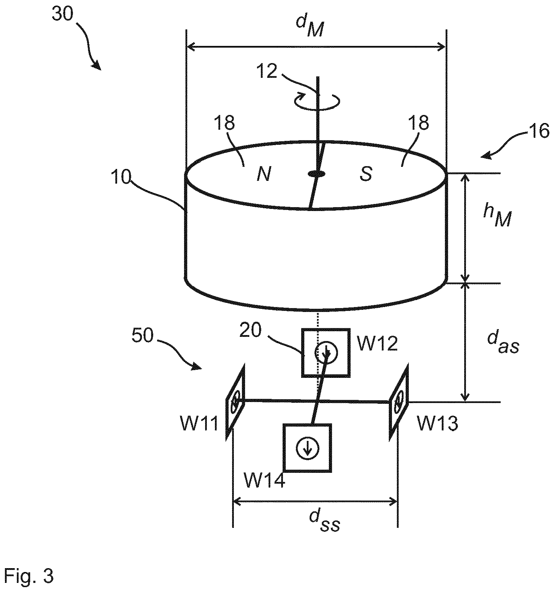

In der Fig. 3 ist ein erstes Ausführungsbeispiel 30 einer Winkelsensorvorrichtung dargestellt. Die Winkelsensorvorrichtung 30 umfasst eine Magnetfelderzeugungseinheit 16 in Form eines dipoligen Permanentmagneten 10 mit einem Nordpol und einem Südpol 18. Diese ist drehfest am Ende einer Rotationsachse 12 angeordnet. In einer axialen Verlängerung zur Rotationsachse 12 ist eine Winkelsensoreinrichtung 50 angeordnet, die auch vier radial gleichmäßig um die Rotationsachse beabstandete Winkelsensoren 20 umfasst. Die Winkelsensoren W11, W12, W13 und W14 weisen jeweils einen Radius dₛₛ/2 als Abstand zur Rotationsachse auf und sind um 90° zueinander versetzt. Die sensitive Ebene der einzelnen Winkelsensoren 20 ist parallel zur Rotationsachse 12 ausgerichtet, so dass Magnetfelder, die parallel zur Drehachse ausgerichtet sind, erfasst werden können. Wirkt ein Störfeld von außen ein, so weichen alle vier Winkelsensoren 20 der Winkelsensoreinrichtung 50 entsprechend von einem Winkel, der durch das Nutzfeld der Magnetfelderzeugungseinrichtung 16 hervorgerufen wird, ab. Da das Nutzfeld in jedem Winkelsensor 20 aufgrund der versetzten Anordnung eine andere Phase aufweist, die Störung allerdings in jedem der Sensoren in etwa gleich wirkt, kann aufgrund der symmetrischen Anordnung der Sensoren W11 bis W14 die Störkomponente herausgefiltert werden.

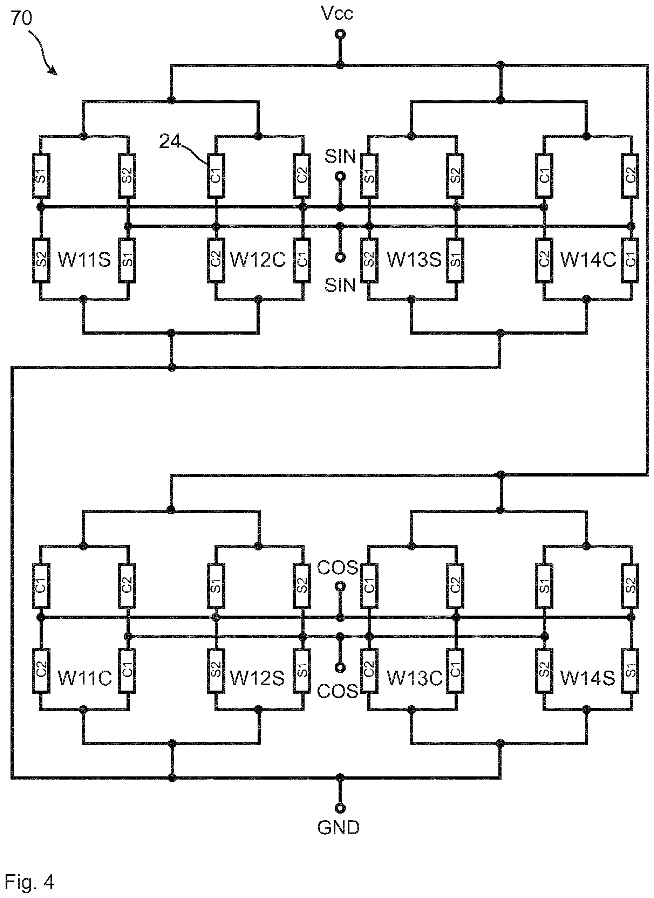

Hierzu zeigt die Fig. 4 eine Wheatstone-Brücke 70, in der phasenrichtig die einzelnen Wheatstone-Brücken der vier Winkelsensoren 20 W11 bis W14 parallel geschaltet sind. Zur Ermittlung der Sinuskomponente werden beispielsweise die Sinusbrücke des Winkelsensors W11, die negative Cosinusbrücke des Winkelsensors W12, die negative Sinusbrücke des Winkelsensors W13 und die Cosinusbrücke des Winkelsensors W14 parallel geschaltet. Diese sind somit phasenrichtig parallel miteinander verschaltet und eine Störung, die sich gleichsam in all diesen Brücken widerspiegelt, kann kompensiert werden. In ähnlicher Weise sind für die Cosinusbrücke die einzelnen Sinus- bzw. Cosinusmessbrücken der einzelnen Sensoren 20 parallel geschaltet. Die Cosinusbrücke des Sensors W11 ist parallel zur Sinusbrücke des Sensors W12, der negativen Cosinusbrücke des Sensors W13 und der negativen Sinusbrücke des Sensors W14 geschaltet, um einen gemittelten Cosinuswert auszugeben. Durch Parallelschaltung und Hartverdrahtung der einzelnen Brücken der Winkelsensoren 20, die phasenrichtig miteinander kombiniert sind, lässt sich die Störung des Störmagnetfelds kompensieren. Die Sinus- und Cosinusbrücken der vier Sensoren 20 sind somit phasenrichtig miteinander verdrahtet und führen eine Signalmitteilung durch. Der Abstand dₐₛ zwischen der Winkelsensoreinrichtung 50 und der Magnetfelderzeugungseinrichtung 16 kann beispielsweise zwischen 1 mm bis 3 mm betragen, wobei der Durchmesser dₘ des Permanentmagneten etwa 6 mm und die Höhe h_{M} des Dipolmagneten etwa 2,5 mm betragen kann. Es ist denkbar, nur zwei oder mehr als vier Winkelsensoren einzusetzen, um eine verbesserte Mittlung zu erreichen, dabei müssen die Phasen entsprechend berücksichtigt werden, oder es muss eine nachträgliche Mittlung mithilfe von Verzögerungsgebern eingefügt werden. Auch können die sensitiven Ebenen der Winkelsensoren rechtwinklig zur Drehachse 12 ausgerichtet sein. Es ist keine elektronische Bearbeitung der Signale erforderlich, um die Störfelder zu unterdrücken, und es kann zumindest ein Faktor 2 an Unterdrückung des Störfelds erreicht werden.

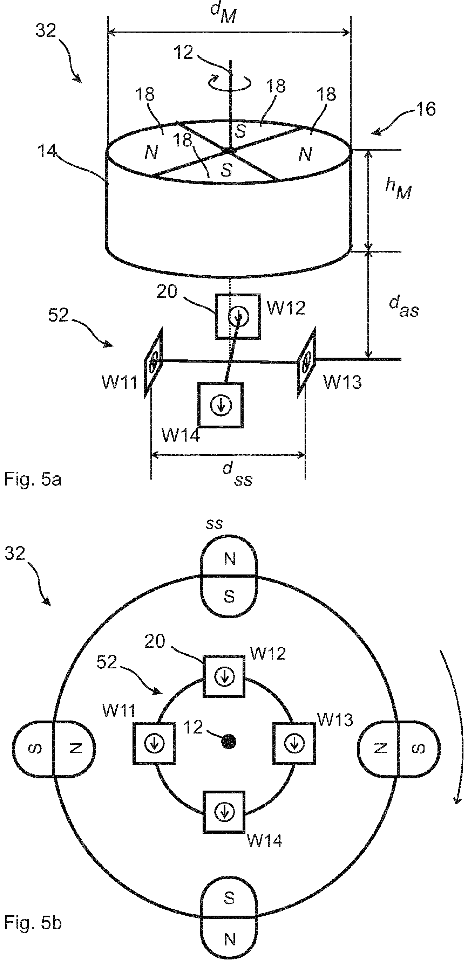

In den Figs. 5a und 5b sind ein weiteres Ausführungsbeispiel 32 einer Winkelsensorvorrichtung dargestellt. Die Ausführung der Fig. 5a entspricht grundsätzlich der Ausführung nach Fig. 3, jedoch wird als Magnetfelderzeugungseinheit 16 ein Quadropolmagnet 14 eingesetzt, der vier Pole 18 umfasst, die abwechselnd polarisiert sind. Hierdurch ist es möglich, eine Abweichung der Drehachse in X- oder Y-Richtung zu erfassen, d. h. eine radiale Abweichung zu erfassen, und somit Unwuchten oder einen verschobenen axialen Verlauf der Drehachse 12 zu detektieren. Dies äußert sich durch eine Phasendifferenz bei der Winkelerfassung der einzelnen Sensoren, wobei allerdings nur eine Erfassung bis 180° möglich ist.
Die Fig. 5a zeigt schematisch eine perspektivische Darstellung der Winkelsensorvorrichtung 32, während Fig. 5b eine Draufsicht darstellt. Hiermit ist eine Zustandsüberwachung der Welle 12 möglich, wobei bei einem wandernden Drehpunkt beispielsweise die Phasendifferenzen zwischen den einzelnen Sensoren sich ändern. Die Ausgangssignale der einzelnen Sensoren können hardwaremäßig miteinander verdrahtet werden, wie dies beispielsweise in der Fig. 4 dargestellt ist. Sie können aber auch einzeln aufbereitet und verarbeitet werden, zum Beispiel durch eine Rechnerlogik einer Winkelberechnungseinrichtung. Eine Zustandsüberwachung der Rotorlage ist möglich, da eine geringfügige Änderung der Drehachsenlage einer Phasendifferenz der Winkelsignale zur Folge hat.

In den Fig. 6a und 6b ist eine weitere Ausführungsform 34 einer erfindungsgemäßen Winkelsensoreinrichtung dargestellt. Die Winkelsensorvorrichtung 34 umfasst eine Magnetfelderzeugungseinrichtung 16, mit einem scheibenförmigen Dipolmagneten 10 mit zwei Polen 18. Der Dipolmagnet 10 ist am axialen Ende einer Rotationsachse 12 angeordnet, weist einen Durchmesser d_{M} und eine Höhe *h_{M}* auf. In axialer Verlängerung der Rotationsachse 12 ist in einem Abstand *dₐₛ₁* ein erster Winkelmesssensor 20 W1 und in einem weiteren Abstand *dₐₛ₂* ein zweiter Winkelsensor 20 W2 der Magnetfelderzeugungseinrichtung 54 angeordnet. Beide Winkelsensoren 20 erfassen das drehende Nutzfeld mit unterschiedlichen Amplituden. Ein Störmagnetfeld wirkt gleichmäßig auf die beiden Winkelsensoren W1 und W2 20 ein, so dass sich eine Winkeländerung der beiden Winkelsensoren in unterschiedlicher Richtung ergeben wird, da die Größe des Nutzfeldes der beiden Winkelsensoren unterschiedlich ist. Diese Auswirkung ist in der Fig. 6b dargestellt, wobei ein Störmagnetfeld Bₑₓₜ in der Ebene der Winkelsensoren wirkt, deren messaktive Ebene rechtwinklig zur Drehachse 12 ausgerichtet ist. Abgewinkelt hierzu steht das Nutzmagnetfeld *B_{M}.* Der Messwinkel, der von dem axial näheren Winkelsensor W1 aufgenommen wird, liegt näher bei der exakten Ausrichtung des Nutzmagnetfelds *B_{M},* während der Winkel des axial weiter entfernten Winkelsensors 20 W2 stärker durch das externe Magnetfeld *Bₑₓₜ* beeinflusst wird. Da die beiden Winkelsensoren 20 mit unterschiedlichem axialem Abstand zentrisch über der Rotationsachse angeordnet sind, sinkt mit dem Abstand die Magnetfeldamplitude des Nutzfeldes, während das Störfeld auf beide Sensoren gleichmäßig einwirkt. Beispielsweise kann bei einem typischen Permanentmessmagneten einer Magnetfelderzeugungseinrichtung der Abstand *dₐₛ₁* 3 mm und der Abstand *dₐₛ₂* 1 mm oder weniger betragen. Der Abstand *dₐₛ₁* kann zwischen 0,5 mm bis 3 mm betragen. Die genannten Abstände, die Abstandsverhältnisse beschreiben sollen, können je nach Stärke des verwendeten Permanentmessmagneten variieren, wobei selbstverständliche größere Abstände möglich sind. Je höher der Abstand zur Magnetfelderzeugungseinrichtung 16 ist, umso stärker wird der Feldwinkel durch das Störfeld beeinflusst. Der Gradient, d. h. die Abweichung der Sensorsignale des Winkelsensors 20 W1 zum Winkelsensor 20 W2 ist umso stärker, je größer das Störfeld ist. Diese Abweichung kann zur Korrektur des Messsignals verwendet werden und der Einfluss des Störfeldes kann dadurch unterdrückt werden. Die Vorrichtung kann sowohl bei Winkelsensoren im engeren Sinne als auch bei einer Kombination von um 90° gedrehten Feldsensoren zur Bestimmung der Feldkomponenten in X- und Y-Richtung angewendet werden.

Beispielsweise erfasst der axial nähere Winkelsensor W1 das Nutzfeld mit einem Winkel ϕ1. Der Sensor W2 weist einen größeren Abstand auf und erfasst einen Winkel ϕ2. Sofern kein Störmagnetfeld vorhanden ist, gilt ϕ1 = ϕ2. Liegt ein homogenes Störmagnetfeld vor, so ergeben sich zwei Winkelfehler ϑ1 und ϑ2, wobei gilt ϑ1 < ϑ2. Dies resultiert daher, dass das einwirkende Nutzfeld auf die beiden Winkelsensoren W1 und W2 unterschiedlich stark ist. Für eine anfängliche Kalibrierung bzw. Eichung sollte ϑ1 und ϑ2 bekannt sein, wobei ϑ1 auf jeden Fall bestimmt werden muss. Eine Kalibrierung bzw. Ermittlung eines Korrekturfaktors kann dadurch stattfinden, dass bei mehreren Größen von Nutzfeldern und bei mehreren Größen von Störfeldern die Winkel ϕ1 und ϕ2 sowie ϑ1 bestimmt werden. Daraus lässt sich eine Winkeldifferenz δ = ϕ1-ϕ2 bestimmen und ein Korrekturfaktor K = ϑ1/δ = ϑ1/(ϕ1-ϕ2) für alle eingesetzten Nutzfelder und in diesem Fall bekannten Störfelder kann errechnet werden. Hierdurch ergibt sich ein Korrekturfaktor bzw. eine Kennlinie oder ein Kennfeld von Korrekturfaktoren für unterschiedliche Nutzfelder und unterschiedliche Störfelder. Bei einer Messung können die beiden Winkel ϕ1 und ϕ2 bestimmt werden und dann eine Korrektur des wahren Winkels ϕ = ϕ1-K·(ϕ1- ϕ2) erreicht werden. Es ist weiterhin denkbar, einen zusätzlichen Magnetfeld- oder Winkelsensor vorzusehen, der außerhalb der Winkelsensoreinrichtung angeordnet ist, und der Stärke und Richtung des Störmagnetfeldes zur Bestimmung des Korrekturfaktors K erfasst. Damit lässt sich effektiv ein Störfeld kompensieren.

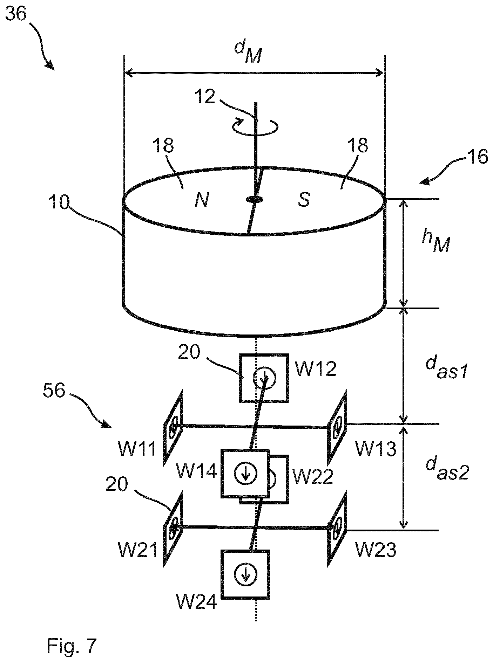

In der Fig. 7 ist ein weiteres Ausführungsbeispiel 36 einer Winkelsensorvorrichtung dargestellt. Diese entspricht im Wesentlichen einer Kombination des in Fig. 6a dargestellten Ausführungsbeispiels 34 und dem in Fig. 5a dargestellten Ausführungsbeispiel 32. Die Winkelsensoren 20 der Winkelsensoreinrichtung 56 sind sowohl radial beabstandet als auch axial beabstandet und umfassen in einer ersten axial näheren Gruppe W11 bis W14 vier Winkelsensoren 20, die jeweils um 90° radial versetzt um die Rotationsachse 12 angeordnet sind, und die beispielsweise hart verdrahtet einen ersten Winkel ϕ1 ausgeben können. In einem axialen Abstand *dₐₛ₂* hiervon findet sich eine weitere Gruppe von Winkelsensoren 20 W21 bis W24. In dieser Anordnung können sowohl durch die radiale Versetzung Störfelder unterdrückt werden, als auch durch die axiale Versetzung mithilfe eines Korrekturfaktors ein weiterer Einfluss von Störfeldern unterdrückt werden, so dass eine verbesserte Störfeldkompensation ermöglicht wird.

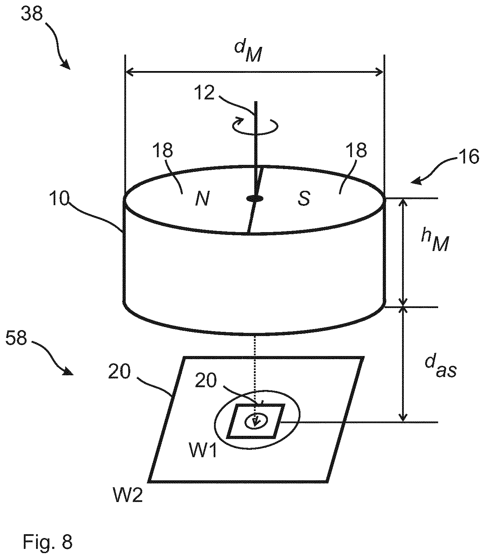

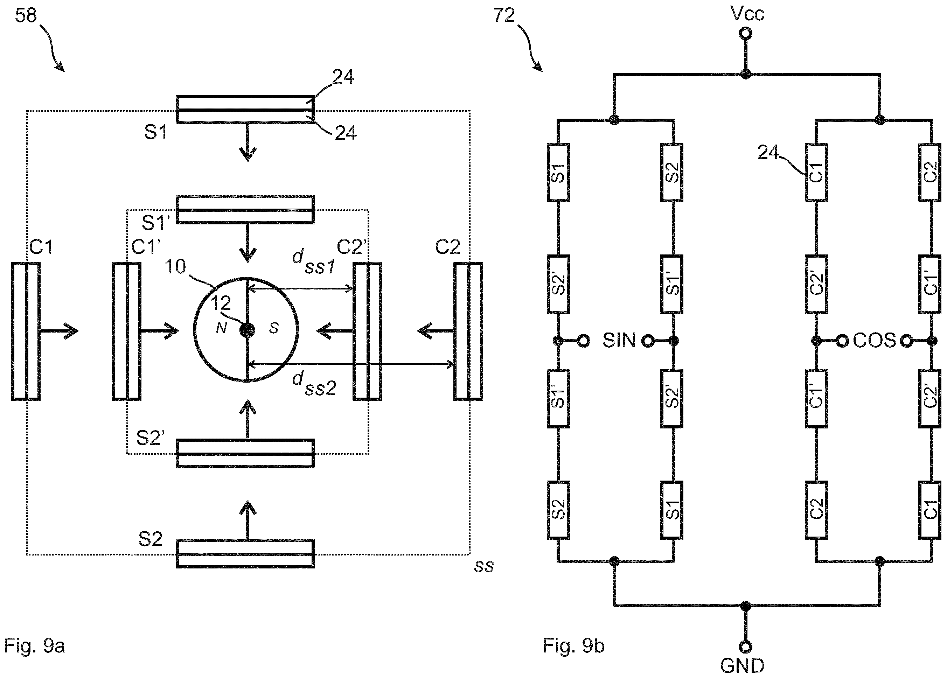

Die Fig. 8 zeigt ein weiteres Ausführungsbeispiel 38 einer Winkelsensorvorrichtung. Hierbei ist in einem axialen Abstand *dₐₛ* von der Magnetfelderzeugungseinrichtung 16 eine Winkelsensoreinrichtung 58 angeordnet, die zwei Winkelsensoren 20 W1 und W2 umfasst. Beide Winkelsensoren 20 sind auf einem gemeinsamen Chipsubstrat angeordnet und umfassen jeweils eine Sinusbrücke und eine Cosinusbrücke aus magnetoresistiven Widerstandselementen. Die Widerstandselemente 24 des ersten Winkelsensors 20 W1 und des zweiten Winkelsensors 20 W2 sind in einer Ebene rechtwinklig zur Rotationsachse 12 angeordnet. Die Widerstandselemente 24 sind jeweils entlang der Kanten eines Quadrates bzw. eines Kreises um die Rotationsachse 12 angeordnet, wobei die Widerstandselemente 24 des ersten Winkelsensors 20 W1 axial näher an der Rotationsachse 12 als die Widerstandselemente 24 des zweiten Winkelsensors 20 W2 angeordnet sind. Die Anordnung der einzelnen Widerstandselemente 24 ist in der Fig. 9a dargestellt. Die Widerstandselemente 24 C1', S1', S2' und C2' des ersten Winkelsensors 20 W1 finden sich in einem nahen Abstand *dₛₛ₁* zur Rotationsachse 12, und die Widerstandselemente 24 des zweiten Winkelsensors W2 S1, C1, C2 und S2 befinden sich in einem größeren Abstand *dₛₛ₂* zur Rotationsachse.

In der Fig. 9b ist eine Wheatstone-Brücke 72 dargestellt, in der die einzelnen Widerstandselemente 24 der beiden Winkelsensoren 20 W1, W2 derart hart miteinander verschaltet sind, dass die Winkelsensoren 20 sich entgegengesetzt zueinander bezüglich des Nutzmagnetfelds verhalten. So sind in Reihe in einem Zweig der Sinusbrücke die Elemente S1 und S2' sowie die Elemente S1' und S2 geschaltet und im gegenüberliegenden Zweig die Elemente S1', S2 und S1 und S2' geschaltet. In der Cosinusbrücke ist die Anordnung ebenso gewählt. Hierdurch kompensieren sich teilweise die Nutzsignale der beiden Winkelsensoren, wobei das Grundprinzip darauf beruht, dass der eine Winkelsensor von einem stärkeren Nutzfeld als der andere Winkelsensor durchsetzt wird. Insofern gibt die Gesamtschaltung 72 der Fig. 9b einen gedämpften Sinus- und einen gedämpften Cosinuswert aus. Ein Störfeld, das auf alle Widerstandselemente 24 gleichsam einwirkt, würde komplett kompensiert werden, da die jeweils gleichgerichteten Widerstandselemente 24 der beiden Winkelsensoren 20 W1, W2 sich praktisch vollständig gegenseitig kompensieren. Dadurch, dass aufgrund der unterschiedlichen radialen Abstände *dₛₛ₁, dₛₛ₂* der Widerstandselemente 24 der Messbrücken 72 des ersten Winkelsensors W1 zum zweiten Winkelsensor 20 W2, die achsnäher liegenden Widerstandselemente 24 stärker vom Nutzfeld als die achsferneren Widerstandselemente 24 durchsetzt werden, lässt sich ein Winkelwert bestimmen. In der Regel wirkt das Nutzfeld auf die radial innenliegenden Widerstandselementen 24 des Winkelsensors W1 stärker als auf die radial außen liegenden Widerstandselemente 24 des Winkelsensors W2, so dass der dominante Anteil des Nutzwinkelsignals von dem Winkelsensor W1 generiert wird. Der Winkelsensor W2 kompensiert in abgeschwächtem Maße dieses Nutzsignal, und kompensiert ein externes Störsignal praktisch vollständig. Wie in Fig. 9b dargestellt ist, kann die Schaltung hardwaremäßig verdrahtet werden, so dass ein Gesamtwinkelwert herausgegeben werden kann, und keine nummerische Nachberechnung notwendig ist. Insbesondere eignet sich dieses Ausführungsbeispiel für die Anwendung in GMR- oder TMR-Widerstandselemente 24, da diese richtungsabhängig gepinnt werden können und somit eine 360° Erfassung ermöglichen, und eine hohe Empfindlichkeit aufweisen.

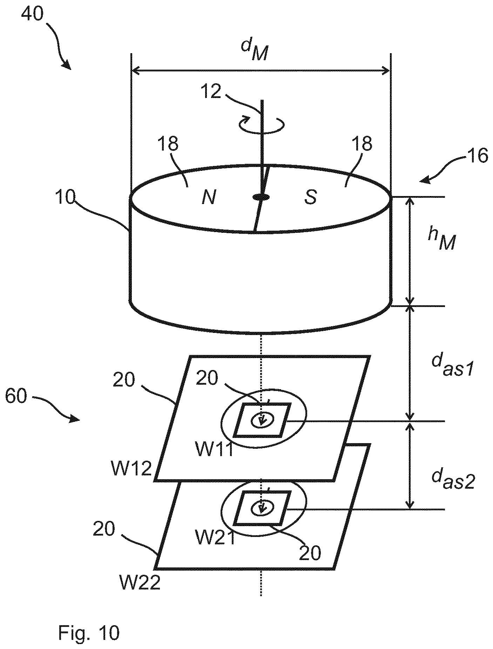

In der Fig. 10 ist ein weiteres Ausführungsbeispiel 40 dargestellt, das sich grundsätzlich aus einer Kombination der in Fig. 8 dargestellten Ausführungsform und der in Fig. 6a dargestellten Ausführungsform ergibt. Somit ist sowohl eine radiale Versetzung der Widerstandselemente 24 zweier Gruppen von zwei Winkelsensoren W11, W12 und W21, W22 eingesetzt, als auch durch die Gradientenausnutzung verschiedener axialer Abstände der Abstände dₐₛ₁ und dₐₛ₂ der beiden Gruppen W11, W12 und W21, W22 und die Berücksichtigung eines Korrekturfaktors eine weitere Störfeldunterdrückung möglich. Insbesondere dreidimensionale Störfelder, die sowohl in axialer als auch in radialer Richtung auf die Winkelerfassungseinheit 60 einwirken, können hierdurch effektiv unterdrückt werden.

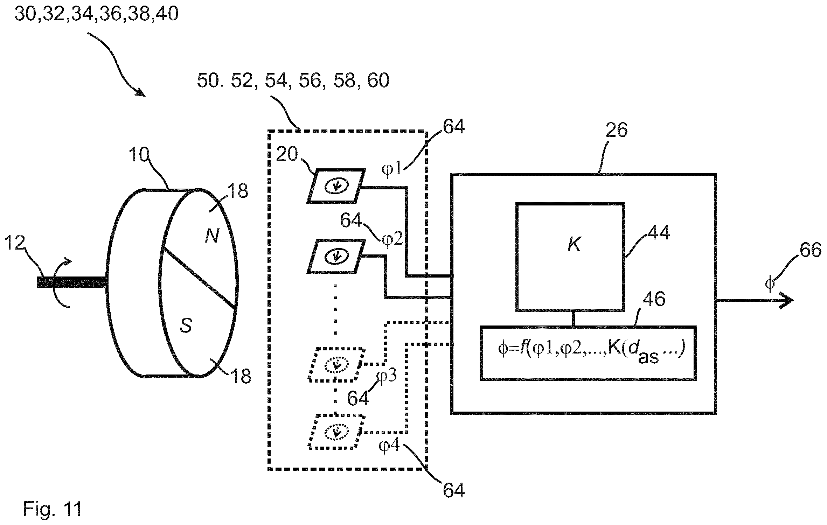

Schließlich zeigt Fig. 11 ein Ausführungsbeispiel einer Winkelsensoreinrichtung, bei denen Winkelwerte einzelner Winkelsensoren 20 einer Winkelsensoreinrichtung 50, 52, 54, 56, 58 oder 60 nach den Ausführungsformen 30, 32, 34, 36, 38 oder 40 einzelerfasst werden. Die Winkelberechnungseinrichtung 26 umfasst einen Kennwertspeicher 44, der verschiedene Kennwerte *K* für verschiedene Nutzfeldgrößen und Störfeldgrößen umfasst, sowie eine Berechnungseinheit 46, die einen störfeldkompensierten Winkel ϕ als Funktion von zwei oder mehreren gemessenen Winkeln der in der Winkelsensoreinrichtung 50, 52, 54, 56, 58 oder 60 umfassten Winkelsensoren 20 erfasst werden, bestimmt. Die Winkelsensoren 20 oder Gruppen von Winkelsensoren 20 sind in verschiedenen axialen Abständen zur Magnetfelderzeugungseinrichtung 16 angeordnet, wobei ein Kennfeld K, das aus dem Kennwertspeicher 44 ausgelesen werden kann, zur Korrektur des Störfeldeinflusses herangezogen wird. Schließlich wird ein störfeldkompensierter Winkelwert ϕ66 ausgegeben.

Die Erfindung schlägt mehrere Ausführungsbeispiele von Winkelsensorvorrichtungen 30, 32, 34, 36, 38 oder 40 vor, bei denen zwei oder mehrere Winkelsensoren 20 in einer Winkelsensoreinrichtung 50, 52, 54, 56, 58 oder 60 eingesetzt werden, die sowohl axial als auch radial versetzt um eine Rotationsachse 12 in der Nähe einer Magnetfelderzeugungseinrichtung 16 angeordnet sind. Auf Basis eines Gradienten der Winkelmessung, d. h. unterschiedliche Winkelerfassungen der einzelnen Winkelsensoren 20, kann ein Einfluss eines Störfelds bestimmt und kompensiert werden. Dabei sind die geometrischen Verhältnisse als auch Kompensationseffekte aufgrund verschiedener räumlicher Anordnungen nutzbar. Die Störfeldkompensation kann zum einen hardwareseitig fest verdrahtet vorgesehen sein, andererseits mittels einer Berechnungseinheit nachträglich durchgeführt werden. Mithilfe einer erfindungsgemäßen Winkelsensorvorrichtung 30, 32, 34, 36, 38 oder 40 lassen sich effektiv Störfelder auch im Bereich von bis zu 3.000 A/m Feldstärke kompensieren, so dass die neue ISO-11452-8:2015 eingehalten werden kann.

### Bezugszeichenliste

- 10: Permanentmagnet, Dipolmagnet
- 12: Rotationsachse
- 14: Permanentmagnet, Quadropolmagnet
- 16: Magnetfelderzeugungseinrichtung
- 18: Magnetpol
- 20: Winkelsensor
- 22: Wheatstone-Messbrücke eines Winkelsensors
- 24: magnetoresistives Widerstandselement
- 26: Winkelberechnungseinrichtung

- 30: Erstes Ausführungsbeispiel einer Winkelsensorvorrichtung
- 32: Zweites Ausführungsbeispiel einer Winkelsensorvorrichtung
- 34: Drittes Ausführungsbeispiel einer Winkelsensorvorrichtung
- 36: Viertes Ausführungsbeispiel einer Winkelsensorvorrichtung
- 38: Fünftes Ausführungsbeispiel einer Winkelsensorvorrichtung
- 40: Sechstes Ausführungsbeispiel einer Winkelsensorvorrichtung

- 44: Kennwert-Speicher
- 46: Berechnungseinheit

- 50: Winkelsensoreinrichtung des ersten Ausführungsbeispiels
- 52: Winkelsensoreinrichtung des zweiten Ausführungsbeispiels
- 54: Winkelsensoreinrichtung des dritten Ausführungsbeispiels
- 56: Winkelsensoreinrichtung des vierten Ausführungsbeispiels
- 58: Winkelsensoreinrichtung des fünften Ausführungsbeispiels
- 60: Winkelsensoreinrichtung des sechsten Ausführungsbeispiels

- 64: Sensorsignale oder Winkelwert eines Winkelsensors
- 66: Störfeldkompensierter Winkelwert

- 70: Wheatstone-Brücke des Winkelsensors des ersten Ausführungsbeispiels
- 72: Wheatstone-Brücke des Winkelsensors des fünften Ausführungsbeispiels

- 100: Winkelsensorvorrichtung aus dem Stand der Technik
- 102: Winkelsensoreinrichtung des Stands der Technik

## Patentansprüche

1. Störfeldkompensierte Winkelsensorvorrichtung (30, 32, 34, 36, 38, 40) zur magnetfeldbasierten Bestimmung eines Drehwinkels einer Rotationsachse (12) umfassend einer Magnetfelderzeugungseinrichtung, insbesondere einen Permanentmagneten (10, 14), und eine Winkelsensoreinrichtung (50, 52, 54, 56, 58, 60), wobei ein Magnetfeld der Magnetfelderzeugungseinrichtung (16) relativ zur Winkelsensoreinrichtung (50, 52, 54, 56, 58, 60) rotiert, und die Winkelsensoreinrichtung (50, 52, 54, 56, 58, 60) zumindest zwei Winkelsensoren (20) zur Erfassung unterschiedliche Magnetfeldbereiche des Magnetfelds der Magnetfelderzeugungseinrichtung umfasst, **dadurch gekennzeichnet, dass** die Winkelsensoren (20) axial in verschiedene Abständen entlang der Rotationsachse (12) und/oder die Winkelsensoren (20) radial in verschiedenen Abständen zur Rotationsachse (12) zur Erfassung unterschiedlicher Amplituden des Magnetfelds versetzt angeordnet sind, so dass durch eine Gradientenbildung der Winkelwerte oder Sensorsignale (64) der Winkelsensoren (20) ein Einfluss eines Störfeldes kompensierbar ist.

2. Winkelsensorvorrichtung (30, 32, 34, 36, 38, 40) nach Anspruch 1, **dadurch gekennzeichnet, dass** die Magnetfelderzeugungseinrichtung (16) als Permanentmagnet (10, 14), insbesondere als Dipolmagnet (10) ausgebildet ist, der an einer Stirnfläche der Rotationsachse (12) drehfest angeordnet ist, und die Winkelsensoreinrichtung (50, 52, 54, 56, 58, 60) in axialer Verlängerung der Rotationsachse (12) gegenüberliegend zur Stirnfläche der Rotationsachse (12) angeordnet ist.

3. Winkelsensorvorrichtung (30, 32, 34, 36, 38, 40) nach einem der vorgenannten Ansprüche, **dadurch gekennzeichnet, dass** die Winkelsensoren xMR-Winkelsensoren (20), insbesondere AMR-, TMR- oder GMR-Sensoren sind.

4. Winkelsensorvorrichtung (30, 32, 34, 36, 38, 40) nach einem der vorgenannten Ansprüche, **dadurch gekennzeichnet, dass** jeder Winkelsensor (20) eine Wheatstone-Messbrücke (22, 70, 72) aus magnetoresistiven Widerstandselementen (24) umfasst, wobei die Wheatstone-Messbrücken (22, 70, 72) der verschiedenen Winkelsensoren (20) miteinander hart verdrahtet sind, und einen störfeldkompensierten Winkelsensorwert (66) ausgeben.

5. Winkelsensorvorrichtung (30, 32, 34, 36, 38, 40) nach einem der vorgenannten Ansprüche 1 bis 3, **dadurch gekennzeichnet, dass** eine Winkelberechnungseinrichtung (26) umfasst ist, die Winkelwerte (64) oder Sensorsignale jedes Winkelsensors (20) der Winkelsensoreinrichtung (50, 52, 54, 56, 58, 60) empfängt und zur Berechnung eines störfeldkompensierten Winkelwertes (66) verarbeitet.

6. Winkelsensorvorrichtung (30, 32, 34, 36, 38, 40) nach einem der vorgenannten Ansprüche, **dadurch gekennzeichnet, dass** die Winkelsensoren (20) der Winkelsensoreinrichtung (50, 52, 54, 56, 58, 60) achszentrisch angeordnet sind.

7. Winkelsensorvorrichtung (30, 32, 34, 36, 38, 40) nach Anspruch 6, **dadurch gekennzeichnet, dass** jeder Winkelsensor (20) eine Wheatstone-Messbrücke (22, 70, 72) aus magnetoresistiven Widerstandselementen (24) umfasst, wobei die jeweiligen radialen Abstände der magnetoresistiven Widerstandselemente (24) der Wheatstone-Messbrücke (22, 70, 72) jedes Winkelsensors (20) von der Rotationsachse (12) verschieden sind.

8. Winkelsensorvorrichtung (30, 32, 34, 36, 38, 40) nach Anspruch 7, **dadurch gekennzeichnet, dass**, die radial versetzten magnetoresistiven Widerstandselemente (24) der Winkelsensoren (20) gegensinnig zu einer sich kompensierenden Wheatstone-Messbrücken (22, 70, 72) verschaltet sind.

9. Winkelsensorvorrichtung (30, 32, 34, 36, 38, 40) nach Anspruch 8, **dadurch gekennzeichnet, dass** die Magnetfelderzeugungseinrichtung (16) einen Permanentmagneten (10, 14) mit einer gleichen Anzahl von Polen wie Winkelsensoren (20) umfasst, insbesondere einen Quadropolmagneten (14) umfasst.

10. Winkelsensorvorrichtung (30, 32, 34, 36, 38, 40) nach einem der vorgenannten Ansprüche, **dadurch gekennzeichnet, dass** die axialen Positionen zweier Gruppen von Winkelsensoren (20), verschieden sind.

11. Verfahren zur störfeldkompensierten Winkelbestimmung einer Rotationsachse (12) unter Verwendung einer Winkelsensorvorrichtung (30, 32, 34, 36, 38, 40) nach einem der vorgenannten Ansprüche, **dadurch gekennzeichnet, dass** eine Winkelabweichung zwischen den Winkelsensoren (20) der Winkelsensoreinrichtung (50, 52, 54, 56, 58, 60) zur Kompensation eines externen Störfeldes herangezogen wird.

12. Verfahren nach Anspruch 11, **dadurch gekennzeichnet, dass** ein Korrekturfaktor oder eine Kennlinie oder ein Kennfeld von Korrekturfaktoren zur Kompensation eines externen Störfelds herangezogen wird.

13. Verfahren nach Anspruch 12, **dadurch gekennzeichnet, dass** der Korrekturfaktor, oder die Kennlinie oder das Kennfeld bei Herstellung der Winkelsensorvorrichtung (30, 32, 34, 36, 38, 40) in einem Kalibrationsschritt unter Verwendung verschiedener magnetischer Stör- und Nutzfelder bestimmt wird.

14. Verfahren nach einem der Ansprüche 12 oder 13, **dadurch gekennzeichnet, dass** der Korrekturfaktor einen Einfluss eines axialen Abstands der Winkelsensoren (20) und / oder eines radialen Abstands von magnetoresistiven Widerstandselemente (24) der Wheatstone-Messbrücke (22, 70, 72) der Winkelsensoren (20) berücksichtigt.

## Claims

1. Interference field-compensated angle sensor device (30, 32, 34, 36, 38, 40) for magnetic field-based determination of a rotation angle of a rotation axis (12) comprising a magnetic field generating unit, in particular a permanent magnet (10, 14), and an angle sensor unit (50, 52, 54, 56, 58, 60), with a magnetic field of the magnetic field generating unit (16) rotating relative to the angle sensor unit (50, 52, 54, 56, 58, 60), and the angle sensor unit (50, 52, 54, 56, 58, 60) comprising at least two angle sensors (20) for sensing different magnetic field areas of the magnetic field of the magnetic field generating unit, **characterized in that** the angle sensors (20) are arranged axially offset at different distances along the rotation axis (12) and/or the angle sensors (20) are arranged radially offset at different distances to the rotation axis (12) for sensing different amplitudes of the magnetic field, such that an influence of an interference field is compensatable by a gradient formation of the angle values or sensor signals (64) of the angle sensors (20).

2. Angle sensor device (30, 32, 34, 36, 38, 40) according to claim 1, **characterized in that** the magnetic field generating unit (16) is designed as a permanent magnet (10, 14), in particular as a dipole magnet (10), which is arranged non-rotatably on an end face of the rotation axis (12), and the angle sensor unit (50, 52, 54, 56, 58, 60) is arranged in an axial extension of the rotation axis (12) opposite the end face of the rotation axis (12).

3. Angle sensor device (30, 32, 34, 36, 38, 40) according to one of the aforementioned claims, **characterized in that** the angle sensors are xMR angle sensors (20), in particular AMR, TMR or GMR sensors.

4. Angle sensor device (30, 32, 34, 36, 38, 40) according to one of the aforementioned claims, **characterized in that** each angle sensor (20) comprises a Wheatstone bridge (22, 70, 72) of magnetoresistive resistor elements (24), the Wheatstone bridges (22, 70, 72) of the different angle sensors (20) being hardwired to one another and outputting an interference field-compensated angle sensor value (66).

5. Angle sensor device (30, 32, 34, 36, 38, 40) according to one of the aforementioned claims 1 to 3, **characterized in that** an angle computation unit (26) is comprised that receives angle values (64) or sensor signals of each angle sensor (20) of the angle sensor unit (50, 52, 54, 56, 58, 60) and processes them to calculate an interference field-compensated angle value (66).

6. Angle sensor device (30, 32, 34, 36, 38, 40) according to one of the aforementioned claims, **characterized in that** the angle sensors (20) of the angle sensor unit (50, 52, 54, 56, 58, 60) are arranged axis-centric.

7. Angle sensor device (30, 32, 34, 36, 38, 40) according to claim 6, **characterized in that** each angle sensor (20) comprises a Wheatstone bridge (22, 70, 72) of magnetoresistive resistor elements (24), the respective radial distances between the magnetoresistive resistor elements (24) of the Wheatstone bridge (22, 70, 72) of each angle sensor (20) from the rotation axis (12) differing.

8. Angle sensor device (30, 32, 34, 36, 38, 40) according to claim 7, **characterized in that** die radially offset magnetoresistive resistor elements (24) of the angle sensors (20) are connected in opposite directions to form a self-compensating Wheatstone bridge (22, 70, 72).

9. Angle sensor device (30, 32, 34, 36, 38, 40) according to claim 8, **characterized in that** the magnetic field generating unit (16) comprises a permanent magnet (10, 14) with the same number of poles as angle sensors (20), in particular a quadrupole magnet (14).

10. Angle sensor device (30, 32, 34, 36, 38, 40) according to one of the aforementioned claims, **characterized in that** the axial positions of two groups of angle sensors (20) differ.

11. Method for interference field-compensated angle determination of a rotation axis (12) using an angle sensor device (30, 32, 34, 36, 38, 40) according to one of the aforementioned claims, **characterized in that** an angle divergence between the angle sensors (20) of the angle sensor unit (50, 52, 54, 56, 58, 60) is used for compensation of an external interference field.

12. Method according to claim 11, **characterized in that** a correction factor or a characteristic curve or a characteristic field of correction factors is used for compensation of an external interference field.

13. Method according to claim 12, **characterized in that** the correction factor or the characteristic curve or the characteristic field is determined during manufacture of the angle sensor device (30, 32, 34, 36, 38, 40) in a calibration step using various magnetic interference fields and useful fields.

14. Method according to one of claims 12 or 13, **characterized in that** the correction factor takes into account an influence of an axial distance of the angle sensors (20) and / or a radial distance of magnetoresistive resistor elements (24) of the Wheatstone bridge (22, 70, 72) of the angle sensors (20).

## Revendications

1. Dispositif à capteurs angulaires (30, 32, 34, 36, 38, 40) à compensation de champs parasites, destiné à la détermination à base du champ magnétique d'un angle de rotation d'un axe de rotation (12), comprenant un dispositif de génération de champ magnétique, notamment un aimant permanent (10, 14), et un agencement de capteurs angulaires (50, 52, 54, 56, 58, 60), sachant qu'un champ magnétique du dispositif de génération de champ magnétique (16) tourne par rapport à l'agencement de capteurs angulaires (50, 52, 54, 56, 58, 60), et que l'agencement de capteurs angulaires (50, 52, 54, 56, 58, 60) comprend au moins deux capteurs angulaires (20) pour acquérir différentes zones du champ magnétique de l'agencement de capteurs angulaires, **caractérisé en ce que** les capteurs angulaires (20) sont disposés de manière décalée axialement à différents écarts le long de l'axe de rotation (12) et/ou que les capteurs angulaires (20) sont disposés de manière décalée radialement à différents écarts par rapport à l'axe de rotation (12) pour acquérir différentes amplitudes du champ magnétique de telle sorte que, au moyen d'une formation du gradient des valeurs angulaires ou des signaux de détection (64) des capteurs d'angle (20), une influence d'un champ parasite peut être compensée.

2. Dispositif à capteurs angulaires (30, 32, 34, 36, 38, 40) selon la revendication 1, **caractérisé en ce que** le dispositif de génération de champ magnétique (16) est conçu sous forme d'aimant permanent (10, 14), notamment d'aimant dipolaire (10) qui est disposé de manière solidaire en rotation sur une surface avant de l'axe de rotation (12), et que l'agencement de capteurs angulaires (50, 52, 54, 56, 58, 60) est disposé en face de la surface avant de l'axe de rotation (12) dans le prolongement axial de l'axe de rotation (12).

3. Dispositif à capteurs angulaires (30, 32, 34, 36, 38, 40) selon une des revendications précédentes, **caractérisé en ce que** les capteurs angulaires sont des capteurs angulaires (20) xMR, notamment des capteurs AMR, TMR ou GMR.

4. Dispositif à capteurs angulaires (30, 32, 34, 36, 38, 40) selon une des revendications précédentes, **caractérisé en ce que** chaque capteur angulaire (20) comprend un pont de mesure de Wheatstone (22, 70, 72) constitué d'éléments à résistance (24) magnétorésistifs, sachant que les ponts de mesure de Wheatstone (22, 70, 72) des différents capteurs angulaires (20) sont câblés ensemble et donnent une valeur de capteur angulaire (66) à compensation de champs parasites.

5. Dispositif à capteurs angulaires (30, 32, 34, 36, 38, 40) selon une des revendications 1 à 3, **caractérisé en ce qu'**est compris un équipement de calcul angulaire (26) qui reçoit les valeurs angulaires (64) ou les signaux de détection de chaque capteur angulaire (20) de l'agencement de capteurs angulaires (50, 52, 54, 56, 58, 60) et les traite pour calculer une valeur angulaire (66) à compensation de champs parasites.

6. Dispositif à capteurs angulaires (30, 32, 34, 36, 38, 40) selon une des revendications précédentes, **caractérisé en ce que** les capteurs angulaires (20) de l'agencement de capteurs angulaires (50, 52, 54, 56, 58, 60) sont disposés de manière centrée sur l'axe.

7. Dispositif à capteurs angulaires (30, 32, 34, 36, 38, 40) selon la revendication 6, **caractérisé en ce que** chaque capteur angulaire (20) comprend un pont de mesure Wheatstone (22, 70, 72) constitué d'éléments à résistance (24) magnétorésistifs, sachant que les écarts radiaux respectifs des éléments à résistance (24) magnétorésistifs du pont de mesure Wheatstone (22, 70, 72) de chaque capteur angulaire (20), par rapport à l'axe de rotation (12) sont différents.

8. Dispositif à capteurs angulaires (30, 32, 34, 36, 38, 40) selon la revendication 7, **caractérisé en ce que** les éléments à résistance (24) magnétorésistifs des capteurs angulaires (20), décalés radialement sont branchés dans le sens inverse pour former un pont de mesure de Wheatstone (22, 70, 72) à compensation.

9. Dispositif à capteurs angulaires (30, 32, 34, 36, 38, 40) selon la revendication 8, **caractérisé en ce que** le dispositif de génération de champ magnétique (16) comprend un aimant permanent (10, 14) avec le même nombre de pôles que les capteurs angulaires (20), et comprend notamment un aimant quadripolaire (14).

10. Dispositif à capteurs angulaires (30, 32, 34, 36, 38, 40) selon une des revendications précédentes, **caractérisé en ce que** les positions axiales de deux groupes de capteurs angulaires (20) sont différentes.

11. Procédé de détermination angulaire à compensation de champs parasites, d'un axe de rotation (12) en utilisant un dispositif à capteurs angulaires (30, 32, 34, 36, 38, 40) selon une des revendications précédentes, **caractérisé en ce qu'**est utilisée une variation angulaire entre les capteurs angulaires (20) de l'agencement de capteurs angulaires (50, 52, 54, 56, 58, 60) pour la compensation d'un champ parasite externe.

12. Procédé selon la revendication 11, **caractérisé en ce qu'**est utilisé un facteur de correction ou une courbe caractéristique ou un champ caractéristique de facteurs de correction pour la compensation d'un champ parasite externe.

13. Procédé selon la revendication 12, **caractérisé en ce que** lors de la fabrication du dispositif à capteurs angulaires (30, 32, 34, 36, 38, 40), le facteur de correction ou la courbe caractéristique ou le champ caractéristique est déterminé durant une étape de calibrage en utilisant différents champs magnétiques parasites et efficaces.

14. Procédé selon la revendication 12 ou 13, **caractérisé en ce que** le facteur de correction tient compte d'une influence d'un écart axial des capteurs angulaires (20) et/ou d'un écart radial des éléments à résistance magnétorésistifs (24) du pont de mesure de Wheatstone (22, 70, 72) des capteurs angulaires (20).
